# FASCICULE DE BREVET EUROPEEN

(11) **EP 2 962 330 B1**
(45) Date de publication et mention de la délivrance du brevet: **04.11.2020**
(21) Numéro de dépôt: 14705780.6
(22) Date de dépôt: 21.02.2014
(51) Int. Cl.: H01L 27/146, H04N 5/359

(54) **CAPTEUR D'IMAGE AVEC GRILLE D'ANTI-EBLOUISSEMENT**
BILDSENSOR MIT ÜBERLAUFSCHUTZGATE
IMAGE SENSOR WITH ANTI-BLOOMING GATE

(30) Priorité: 28.02.2013 FR 1351786
(43) Date de publication de la demande: 06.01.2016
(73) Titulaire: Teledyne e2v Semiconductors SAS, 38120 Saint-Egrève (FR)
(72) Inventeur: BARBIER, Frédéric, 38120 Fontanil-Cornillon (FR); MAYER, Frédéric, F-38500 Voiron (FR)
(74) Mandataire: Marks & Clerk France
(86) Numéro de dépôt international: PCT/EP2014/053436
(87) Numéro de publication internationale: WO 2014/131704

(56) Documents cités:
- EP-A2- 2 107 610
- WO-A1-2006/119333
- JP-A- H11 261 896
- US-A1- 2011 121 162
- US-A1- 2011 298 079

## Description

L'invention concerne les capteurs d'image électronique à pixels actifs.

Ces capteurs utilisent un réseau de pixels en lignes et en colonnes, avec dans chaque pixel un élément photosensible et plusieurs transistors.

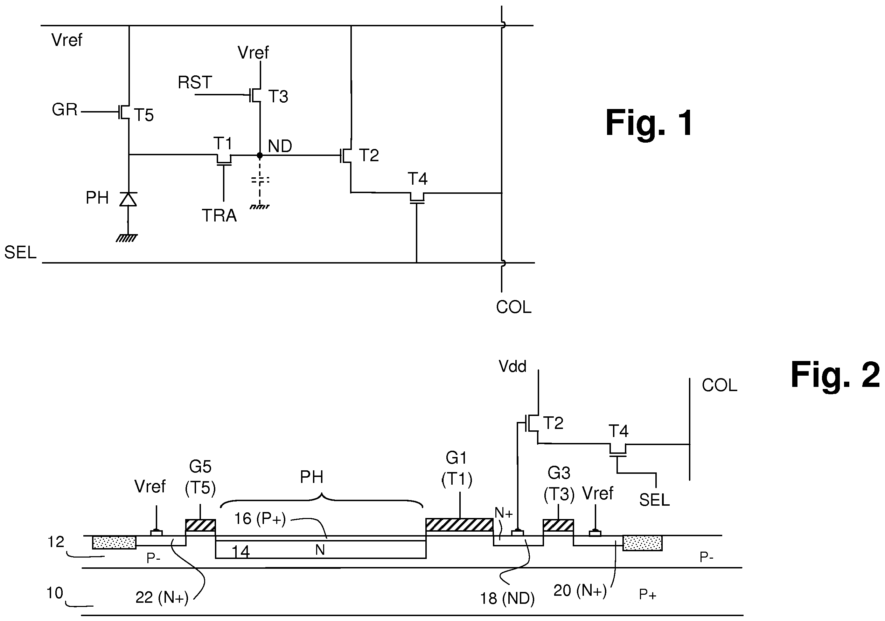

Une constitution avantageuse du pixel est une constitution telle que représentée à la figure 1, avec :
- une photodiode PH autopolarisée (en anglais : pinned photodiode),
- un nœud de stockage de charges ND, qui est l'équivalent d'une capacité,
- un transistor de transfert T1 pour isoler la photodiode du nœud de stockage ou au contraire autoriser un transfert de charges de la photodiode vers le nœud de stockage en vue de mesurer le potentiel du nœud de stockage après ce transfert,
- un transistor T2 de lecture de charges, monté en suiveur de tension, ayant sa grille reliée au nœud de stockage pour permettre de reporter le potentiel du nœud de stockage sur la source du transistor,
- un transistor T3 de réinitialisation du nœud de stockage, permettant de porter à une valeur de référence le potentiel du nœud de stockage pour mesurer ce potentiel de référence, en vue d'une mesure différentielle des potentiels du nœud de stockage en présence de charges issues de la photodiode et en l'absence de charges issues de la photodiode ;
- un transistor T4 de sélection de pixel, commandé par un conducteur SEL d'adressage en ligne, permettant de reporter sur un conducteur de colonne COL le potentiel de la source du transistor de lecture T2 ; le conducteur de ligne SEL est commun à tous les pixels d'une même ligne de pixels ; le conducteur de colonne COL est commun à tous les pixels d'une même colonne de pixels,
- enfin, un transistor supplémentaire T5 qui peut avoir l'une et/ou l'autre des deux fonctions suivantes : évacuer les charges électriques en excédent dans la photodiode en cas d'éclairement trop fort, ou bien réinitialiser le potentiel de la photodiode en vidant complètement les charges accumulées afin qu'elle reprenne son potentiel à vide avant de débuter une nouvelle période d'intégration.

On notera qu'on utilise l'appellation "transistor" pour faciliter la compréhension en termes de schéma électrique tel que le schéma de la figure 1. Toutefois, dans la constitution physique du pixel, ces transistors ne sont pas nécessairement constitués de manière classique, indépendamment des autres éléments du pixel, avec une région de source, une région de drain, une région de canal séparant la source du drain et une grille isolée au-dessus du canal. Dans la constitution physique réelle du pixel, certains transistors sont en réalité constitués essentiellement par une grille isolée à laquelle on peut appliquer un potentiel de commande. Ainsi, par exemple, le transistor de transfert T1 est constitué par une grille de transfert G1 isolée du substrat, surmontant une région qui est située entre la photodiode PH et une diffusion de type N+ constituant le nœud de stockage de charges ; la source du transistor T1 est la photodiode ; le drain du transistor est le nœud de stockage de charges.

Ainsi, la figure 2 représente en coupe la constitution physique du pixel, formé dans un substrat semiconducteur 10, par exemple de type P+. Le substrat comporte à sa partie supérieure une couche active semiconductrice 12 de type P dans laquelle se stockent et se déplacent les électrons.

La photodiode PH est constituée par une région 14 de type N diffusée dans la couche active. Elle est de préférence recouverte par une région superficielle 16 de faible profondeur de type P+, plus dopée que la couche active et portée au potentiel du substrat, qu'on considérera ci-après comme une référence de potentiel nul.

Le nœud de stockage de charges ND est constitué par une diffusion 18 de type N+ dans la couche active. Un contact est pris à sa partie supérieure pour une connexion à la grille du transistor de lecture T2, représenté symboliquement sur la figure 2.

Le transistor de transfert T1 est constitué par une grille de transfert isolée G1 disposée au-dessus d'une portion de la couche active 12, entre la région de photodiode 14 et la diffusion 18 constituant le nœud de stockage.

Le transistor T3 de réinitialisation du noeud de stockage est constitué par une grille isolée G3 située au-dessus de la couche active 12, entre la diffusion 18 et une autre diffusion 20 de type N+ qui constitue un drain porté à un potentiel de référence Vref.

Le transistor T5 de réinitialisation de la photodiode est constitué par une grille isolée G5 située au-dessus de la couche active entre la photodiode PH (régions diffusées 14, 16) et une diffusion 22 de type N+ qui constitue un drain porté à un potentiel de référence qui peut être ou non le même que le potentiel Vref de la diffusion 20. Ici, on considère pour simplifier qu'il s'agit du même potentiel Vref.

Enfin, la constitution physique du transistor de lecture T2 et du transistor de sélection T4 n'est pas représentée sur la figure 2. Le transistor T2 est constitué par une région de source, une région de drain, et entre les deux une grille isolée ; la région de source est une diffusion de type N+ qui sert également de région de source pour le transistor de sélection T4 ; la région de drain du transistor T2 est une diffusion de type N+ qui est portée à un potentiel d'alimentation qui peut être encore le potentiel Vref ; la grille est reliée par un conducteur au nœud de stockage ND. Le transistor T4 comprend, outre sa source, un drain qui est une diffusion N+ reliée au conducteur de colonne COL, et une grille qui est reliée au conducteur de ligne SEL.

Dans ce pixel, les grilles G1 et G3 peuvent servir à réinitialiser simultanément le potentiel du nœud de stockage et celui de la photodiode ; pour cela on porte ces grilles à un potentiel suffisamment positif pour que tous les électrons stockés soit dans le nœud de stockage soit dans la photodiode se déversent vers les drains constitués par les régions 20 et 22. Alternativement, on peut réinitialiser séparément la photodiode par la grille G5 et le nœud de stockage par la grille G3.

Mais en ce qui concerne la grille G5, on peut lui donner une autre fonction qui est une fonction d'anti-éblouissement pendant les temps d'intégration des charges résultant de l'éclairement de la photodiode. On sait que les électrons générés par l'éclairement s'accumulent dans la photodiode et remplissent le puits de potentiel créé dans la région de la photodiode, abaissant progressivement le potentiel de cathode de celle-ci. Le niveau du plancher de ce puits est déterminé par la constitution de la photodiode (valeurs de dopage, profondeurs, etc.). La hauteur des bords du puits de potentiel est déterminée par la hauteur des barrières de potentiel qui encadrent la photodiode ; ces barrières sont établies par les potentiels bas appliqués aux grilles G1 et G5 pendant les périodes d'intégration de charges et par les bords physiques de la photodiode (généralement une barrière à 0 volt en raison d'une implantation P ou P+ sur ces bords). Les charges qui s'accumulent dans le puits y restent jusqu'à ce qu'on applique à la grille G1 une impulsion qui abaisse la barrière de potentiel et qui autorise le passage des charges de la photodiode vers le nœud de stockage.

Cependant, si l'éclairement est fort et/ou si le temps d'intégration est trop long pour un éclairement donné, il peut arriver que les charges remplissent entièrement le puits de potentiel avant le moment où elles doivent être transférées ; si cela se produit, le potentiel de la cathode passe au-dessous de son potentiel d'anode. La photodiode cesse d'être polarisée en inverse, et les charges qui continuent d'être produites par l'éclairement se déversent alors directement dans la couche active. Elles sont collectées par les photodiodes des pixels voisins et polluent le signal d'éclairement mesuré par ces pixels.

Pour y remédier, au lieu de porter la grille G5 au potentiel le plus bas du circuit, on la porte à un potentiel légèrement plus haut qui abaisse un peu la barrière de potentiel établie sous la grille G5. Ainsi, lorsque le puits de potentiel sous la photodiode se remplit, les charges en excédent passent par-dessus cette barrière de potentiel et se déversent vers la région de drain 22 où elles s'évacuent vers la connexion au potentiel Vref. Le potentiel sous la photodiode ne peut jamais atteindre une valeur basse telle que la photodiode devienne polarisée en direct. Les charges en excédent partent vers le drain au potentiel Vref et ne partent pas vers le substrat.

La barrière de potentiel formée sous la grille G5 doit être suffisamment haute pour que le puits de potentiel puisse recueillir une quantité de charges suffisante pour la mesure d'éclairement, mais pas trop haute pour éviter le passage de la photodiode en direct. On rappelle que lorsque les charges électriques sont des électrons, ce qui est le plus souvent le cas, les puits de potentiel formés à l'intérieur de la couche semiconductrice active sont d'autant plus profonds que les potentiels sont plus élevés et les barrières de potentiel qui les encadrent sont d'autant plus hautes que les potentiels dans le semiconducteur sont plus bas. Typiquement, on peut choisir pour établir la barrière de potentiel sous la grille G5 un niveau de potentiel de grille, au-dessus du potentiel du substrat, à peu près égal à la tension de seuil du transistor T5, par exemple environ 0,6 à 1,1 volts (dépendant des dopages, épaisseurs d'isolant de grille, etc.).

Avec un tel dispositif, on a cependant constaté un inconvénient qu'on va maintenant expliquer et que la présente invention vise à supprimer ou au moins réduire dans une large mesure.

Si le potentiel appliqué à la grille G5 est de 0,6 à 1,1 volt, le potentiel dans la couche active 12 sous la grille G5 sera positif, par exemple égal à environ 0,2 volt. Il existe alors un champ électrique important localement sous la grille en surface du silicium vers le bord de la photodiode qui est maintenue à 0 volt par la région superficielle 16. Ce champ électrique agit en abaissant la bande interdite du semiconducteur et en augmentant donc la probabilité de passage d'électrons dans la bande de conduction. Il s'agit là d'un effet physique de tunnel de bande à bande, qui crée un courant de fuite. Des électrons sont générés sous la grille sans que l'éclairement en soit la cause ; ils vont se stocker dans la photodiode dont le potentiel est plus élevé. Ce courant est assimilable à un courant d'obscurité puisqu'il existe indépendamment de l'éclairement. Ce courant d'obscurité, spécifiquement dû à la présence d'une différence entre le potentiel sous la grille et le potentiel de surface de la photodiode, est particulièrement gênant lorsqu'on veut détecter de faibles éclairements. Il peut être plusieurs centaines de fois plus élevé que si le potentiel sous la grille était nul.

Ce phénomène est d'autant plus important que la tension appliquée à la grille G5 est plus différente de zéro ; mais la tension de grille est imposée par le niveau d'anti-éblouissement souhaité, compte-tenu de la technologie. Si la technologie donne au transistor T5 une tension de grille de 0,6 à 0,9 volts, le courant d'obscurité peut être très important. Une solution serait de réaliser le transistor T5 avec une tension de seuil presque nulle, mais cela oblige soit à imposer que tous les transistors du circuit aient une tension de seuil presque nulle soit à prévoir des étapes de fabrication spécifiques pour réaliser le transistor T5.

Pour éviter ce phénomène de courant d'obscurité tout en ayant une grille qui accomplit sa fonction d'anti-éblouissement dans de bonnes conditions, l'invention propose d'appliquer à la grille d'anti-éblouissement un potentiel positif assurant la fonction d'anti-éblouissement pendant une série d'impulsions courtes et non pendant toute la durée d'intégration, la grille étant maintenue à un potentiel nul (voire même négatif) en dehors de ces impulsions et en dehors des phases éventuelles de réinitialisation du potentiel de la photodiode. Pendant ces impulsions courtes, le champ électrique gênant existe mais son effet est bien moindre que s'il existait pendant toute la durée d'intégration. Les impulsions courtes vident les charges en excès si l'éclairement est fort mais il n'est pas nécessaire que ce vidage soit continu ; il suffit qu'il se produise de temps en temps pour empêcher un débordement du puits de potentiel.

Par conséquent l'invention propose un procédé de commande d'un pixel d'un capteur d'image selon la revendication 1.

Le potentiel de blocage est de préférence égal au potentiel de référence nul, mais il pourrait même être négatif. Le potentiel d'anti-éblouissement est positif (pour une couche active de type P) et de préférence compris entre 0,5 et 0,9 volts. Le rapport entre la durée d'intégration et la durée cumulée des impulsions est de préférence supérieur ou égal à 20, c'est-à-dire que les impulsions n'occupent qu'une faible fraction de la durée d'intégration. Les impulsions sont de préférence périodiques et le rapport cyclique entre la période des impulsions et la durée des impulsions est alors supérieur ou égal à 20. La période peut être la période de lecture des lignes de pixels d'un capteur matriciel dans lequel les lignes sont lues les unes après les autres.

Ainsi, pendant la plus grande partie de la durée d'intégration, le phénomène de courant d'obscurité mentionné ci-dessus, dû au champ induit par la grille ne se produit pas, le potentiel sous la grille restant nul. Le phénomène ne se produit que pendant les impulsions brèves d'anti-éblouissement.

L'invention concerne également un capteur d'image comportant un réseau de pixels selon la revendication 8. La couche active est de préférence de type P, ainsi que la couche superficielle de la photodiode. Le potentiel appliqué à la grille en dehors des impulsions d'anti-éblouissement est alors nul (mais pourrait être négatif), et le potentiel appliqué pendant les impulsions d'anti-éblouissement est positif.

Dans cette description, l'expression "drain d'évacuation" définit comme cela est usuel une zone qui élimine des charges et non une zone qui stocke des charges en vue d'une mesure.

On notera qu'on a déjà proposé dans l'art antérieur de faire l'anti-éblouissement de la photodiode en passant par la grille de transfert, le nœud de stockage et le transistor de réinitialisation du nœud de stockage (US 20080122956A1, US 8 278 131). Ce procédé perturbe le fonctionnement normal du nœud de stockage et de plus il ne permet pas de faire fonctionner le pixel autrement qu'en mode dit de "electronic rolling shutter" ou ERS dans lequel les différentes lignes d'image ne sont pas intégrées au même moment.

Dans la publication de brevet US 20090127436A1, le niveau de potentiel de grille d'anti-éblouissement est ajusté en fonction de l'éclairement.

Dans la publication de brevet JP H11 261896, des impulsions sont appliquées à une grille de réinitialisation avant le moment de l'intégration mais pas pendant la durée d'intégration.

Dans la publication de brevet WO 2006/119333, on voit des impulsions appliquées à une grille de lecture des charges adjacente à une diffusion flottante, mais pas à une grille d'anti-éblouissement adjacente à un drain d'évacuation.

Dans la publication de brevet US 2011/121162, il n'y a pas de grille d'anti-éblouissement qui recevrait des impulsions pendant la durée d'intégration.

D'autres caractéristiques et avantages de l'invention apparaîtront à la lecture de la description détaillée qui suit et qui est faite en référence aux dessins annexés dans lesquels :
- la figure 1, déjà décrite, représente un schéma électrique de pixel classique à cinq transistors ;
- la figure 2, déjà décrite, représente en coupe la constitution physique du pixel ;
- la figure 3 représente un diagramme temporel du fonctionnement général du pixel ;
- la figure 4 représente les puits de potentiel formés dans la couche active pendant la durée d'intégration de charges ;
- la figure 5 représente un chronogramme du fonctionnement du capteur selon l'invention, avec une représentation des diagrammes de potentiel à certains instants ;
- la figure 6 représente un chronogramme dans un autre mode de fonctionnement, avec les diagrammes de potentiel.

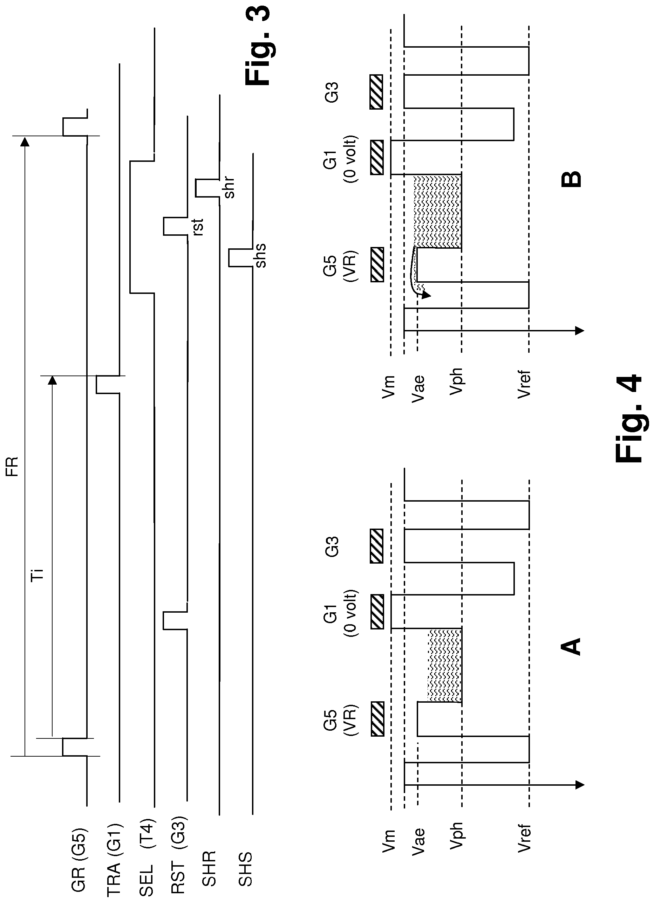

Sur la figure 3, on a représenté le chronogramme de fonctionnement classique d'un pixel à 5 transistors utilisant le cinquième transistor pour déclencher le début de la période d'intégration (fonctionnement en mode dit "global shutter"). Le fonctionnement est périodique avec une période de trame FR ; la durée d'intégration est Ti inférieure à FR. La trame commence par une impulsion de réinitialisation GR appliquée à la grille G5 du transistor T5 pour tous les pixels à la fois. L'impulsion vide les charges qui ont été intégrées par la lumière dans les photodiodes. La fin de l'impulsion GR marque le début de la durée d'intégration Ti, commune à tous les pixels. La fin de cette durée sera définie par la fin d'une impulsion de transfert TRA appliquée à la grille G1 du transistor de transfert T1 ; cette impulsion, commune à tous les pixels, transfère les charges intégrées de la photodiode vers le nœud de stockage.

Au cours de la durée d'intégration, avant l'impulsion TRA, une impulsion de réinitialisation (ligne RST) est appliquée à la grille G3 pour vider les charges qui peuvent être contenues dans le nœud de stockage.

Après la durée d'intégration Ti, les pixels sont lus ligne par ligne, un signal de sélection (ligne SEL) étant appliqué successivement à chacune des lignes pour définir le moment de la lecture. Ce signal est représenté pour une seule ligne sur la figure 3 ; il est appliqué à la grille du transistor T4. La lecture se fait dans un circuit de lecture situé au pied de chaque colonne et relié au conducteur de colonne COL respectif. Le circuit de lecture comprend notamment un circuit d'échantillonnage commandé par des impulsions shs et shr servant à échantillonner respectivement le niveau de potentiel utile du conducteur de colonne après l'impulsion de transfert TRA et le niveau de potentiel après réinitialisation. La mesure est faite par différence entre les deux échantillons à chaque période.

La phase de lecture pour une ligne donnée, définie par le créneau SEL appliqué à cette ligne, comprend successivement l'émission d'une impulsion d'échantillonnage shs, l'émission d'une impulsion RST de réinitialisation du nœud de stockage des pixels de la ligne considérée, et l'émission d'une impulsion d'échantillonnage shr. La différence des signaux échantillonnés est convertie par un convertisseur analogique-numérique.

La figure 4 représente le diagramme des potentiels dans la couche active pendant la période d'intégration, dans le cas d'un éclairement normal (à gauche A) et dans le cas d'un éclairement excessif (à droite B).

Le potentiel intrinsèque de la photodiode en l'absence de charges photogénérées est un niveau fixe Vph qui définit le fond du puits de potentiel formé dans la photodiode. Le potentiel bas appliqué aux grilles G1 et G5 pendant la phase d'intégration induit des barrières de potentiel qui retiennent les charges de la photodiode et permettent leur accumulation. La barrière de potentiel du côté de la grille G1 est la plus haute, un potentiel nul étant appliqué à cette grille pendant la durée d'intégration Ti. Pour assurer une fonction d'anti-éblouissement, la barrière du côté de la grille G5 est plus basse et on applique pour cela à la grille G5 un potentiel VR positif, par exemple entre 0,6 et 1,1 volt. Les niveaux de ces barrières sont indiqués sur la figure 4 par une référence Vm (barrière sous la grille G1) et une référence Vae (barrière d'anti-éblouissement sous la grille G5).

En cas d'éclairement excessif (partie droite de la figure) pendant la durée d'intégration, ou en cas de durée d'intégration trop longue, les charges peuvent déborder du puits et elles débordent du côté de la grille G5 où la barrière est plus basse. Elles sont évacuées vers le drain 22 du transistor T5 sans que le niveau de potentiel de la photodiode risque de descendre au-dessous de zéro volt. La grille G5 est donc bien une grille d'anti-éblouissement permettant d'évacuer vers un drain d'évacuation, et d'éliminer, les charges en excès, pour éviter qu'elles ne partent vers le nœud de stockage à travers la grille de transfert ou plus généralement vers le silicium de la couche active.

Selon l'invention, pour éviter les inconvénients exposés plus haut, liés à l'existence d'un potentiel VR non nul sur la grille G5, on va laisser la grille G5 presque tout le temps au potentiel zéro (qui est le potentiel de la couche active) pendant la durée d'intégration Ti et n'appliquer le potentiel d'anti-éblouissement VR que pendant de courts instants au cours de la durée d'intégration. Si un débordement de charges tend à se produire, ces impulsions évacueront les charges.

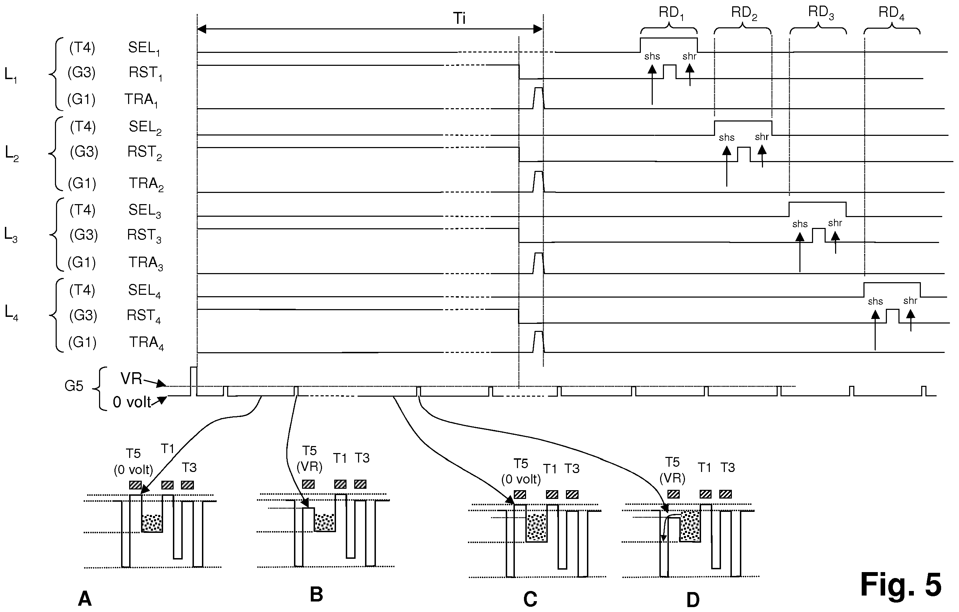

La figure 5 représente le diagramme temporel correspondant et les diagrammes de potentiels associés. Le fonctionnement général, en dehors de la fonction d'anti-éblouissement, est le même qu'à la figure 3 mais on a représenté la lecture de plusieurs lignes successives L1, L2, L3, L4 pour bien montrer le séquencement des opérations.

En dehors de l'impulsion de réinitialisation GR pendant laquelle la grille G5 est portée à un potentiel haut (par exemple 3 volts ou 5 volts) pour vider les charges de la photodiode et démarrer une durée d'intégration Ti, la grille G5 peut être portée à deux potentiels bas qui sont soit 0 volts (ou même un potentiel négatif) soit un potentiel positif VR (par exemple 0,6 volts). Le potentiel 0 volt est appliqué presque tout le temps pendant la durée d'intégration ; le potentiel VR est appliqué seulement pendant des impulsions brèves, de préférence périodiques. La période peut être la période de lecture des lignes successives.

Ainsi, on voit sur la figure 5 les trois potentiels appliqués à la grille G5 : potentiel positif haut en début de période d'intégration, puis potentiel 0 volt et une série d'impulsions au potentiel positif bas VR pendant toute la durée d'intégration. Cette série d'impulsions peut d'ailleurs se poursuivre pendant les phases de lecture RD1, RD2, RD3, RD4, etc. des lignes successives L1, L2, L3, L4, comme cela est représenté sur la figure 5. Mais on peut alternativement appliquer en continu la tension d'anti-éblouissement VR après l'impulsion de transfert TRA pendant les phases de lecture car elle n'a pas d'inconvénient à ce moment là et tant qu'une nouvelle intégration n'a pas démarré.

Quatre diagrammes de potentiel dans la couche active ont été tracés : les diagrammes A et B correspondent au cas d'un éclairement normal, sans risque de débordement. Les diagrammes C et D correspondent à un risque de débordement, par exemple vers la fin de la durée d'intégration en présence d'un éclairement assez fort. Le diagramme A et le diagramme C correspondent à un moment où la grille G5 est portée au potentiel 0, c'est-à-dire presque tout le temps : la barrière de potentiel sous la grille G5 est à son plus haut niveau. Le diagramme B et le diagramme D correspondent au moment d'une impulsion brève d'anti-éblouissement : la barrière de potentiel est brièvement abaissée. Dans le cas du diagramme D, on voit que les charges excédentaires éventuellement accumulées depuis l'impulsion précédente sont dérivées vers le drain du transistor T5 pendant l'impulsion brève d'anti-éblouissement.

La durée cumulée des impulsions pendant l'intégration est de préférence très inférieure à la durée d'intégration Ti, par exemple au moins vingt fois plus faible que la durée d'intégration Ti.

Les impulsions peuvent être appliquées à la fréquence de lecture des lignes et le rapport entre la durée de la période de ligne et la durée de l'impulsion est alors d'au moins vingt. Si la durée de la période de ligne est de 15 microsecondes, la durée des impulsions peut être d'environ 0,5 microsecondes ou moins. Pour une durée d'intégration de 15 millisecondes par exemple, on aura mille impulsions d'anti-éblouissement mais la durée cumulée de l'application de la tension d'anti-éblouissement VR restera trente fois plus faible que la durée d'intégration, réduisant de 30 fois la génération d'électrons parasites par effet tunnel pour un niveau donné de tension VR.

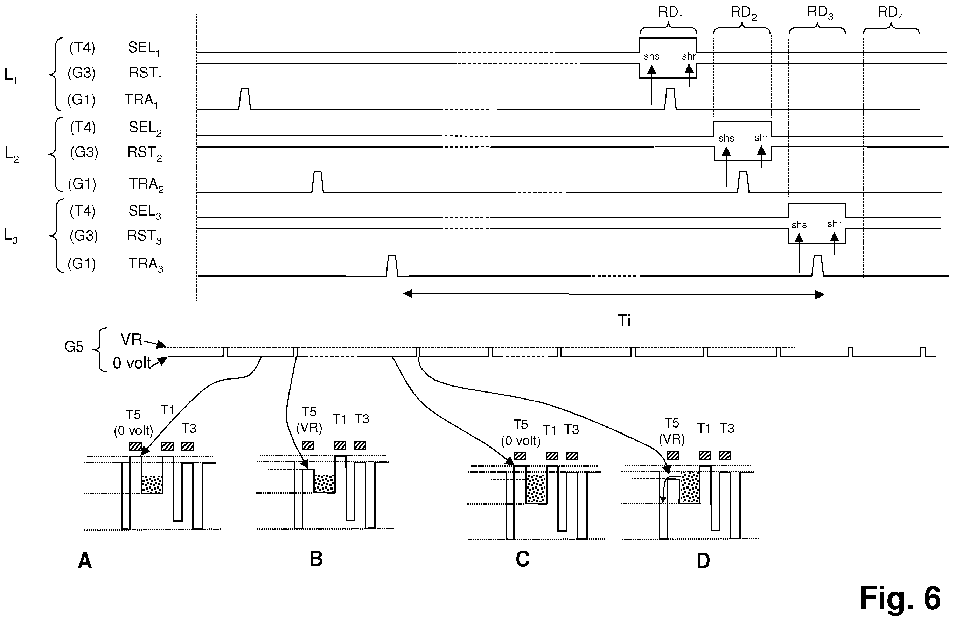

Sur la figure 6, on a représenté le chronogramme dans le cas où la durée d'intégration Ti est égale à la période de trame et a la même valeur pour toutes les lignes mais est décalée dans le temps d'une ligne à l'autre. C'est le mode de fonctionnement connu sous le nom anglais de "Electronic Rolling Shutter" ou ERS (obturateur électronique défilant). Les impulsions de transfert appliquées aux grilles G1 sont décalées dans le temps d'une ligne à la suivante. La durée d'intégration s'étend entre deux impulsions de transfert successives sur la même ligne. Le nœud de stockage est réinitialisé en permanence par la grille G3 sauf pendant la phase de lecture définie par un créneau temporel SELi pour une ligne de rang i. La lecture du niveau de réinitialisation (shr) a lieu avant l'impulsion de transfert TRA et la lecture du niveau utile a lieu juste après cette impulsion TRA. Il n'y a plus de commande de transfert global GR sur la grille G5 pour définir un début d'intégration commun à toutes les lignes. Ce mode de fonctionnement est utilisé parce qu'il réduit le bruit de lecture en raison du fait que la lecture du niveau de réinitialisation précède le transfert de charges et la lecture du niveau utile, ce qui n'est pas le cas dans le mode de fonctionnement de la figure 5.

Dans le mode de fonctionnement de la figure 6, on applique de la même manière des impulsions brèves de tension positive VR sur la grille G5 et on maintient la grille G5 à 0 volt ou même à une tension négative le reste du temps. Les diagrammes de potentiel A, B, C, D sont donc les mêmes qu'à la figure 5.

Dans le cas de la figure 6, comme l'intégration a lieu tout le temps, les impulsions sont appliquées tout le temps, alors que dans le cas de la figure 5 on pouvait prévoir que les impulsions n'ont lieu que pendant la durée Ti mais pas pendant le reste de la trame.

Si la quantité de charges qui risque de faire passer la photodiode en direct est Qsat et si on veut prendre une marge Qmargin pour évacuer le surplus de charges au-delà de Qsat-Qmargin, on peut calculer l'efficacité du système d'anti-éblouissement en fonction de la durée de l'intervalle qui sépare deux impulsions successives. En effet, la limite de l'efficacité est atteinte lorsque l'éclairement est tel que la quantité de charges produite entre deux impulsions successives est égale à la différence Qmargin.

Par exemple, on peut considérer que : la durée d'une impulsion est de 0,5 microseconde (mais pourrait être plus brève), la période est de 15 microsecondes, la saturation Qsat se produit avec 20 000 électrons dans la photodiode, la marge Qmargin souhaitée est de 3 000 électrons. Alors le système est efficace jusqu'à un éclairement produisant 200 électrons par microseconde. Par exemple, si le temps d'intégration est choisi égal à un centième de seconde, et si on constate que le puits de potentiel se remplit de 20 000 électrons en un centième de seconde (2 électrons par microseconde) pour un pixel fortement éclairé mais à la limite de la saturation pour cette durée, alors le système d'anti-éblouissement fonctionne même si un pixel reçoit un éclairement 100 fois supérieur. Si la période des impulsions de ligne est de 30 microsecondes, la limite est atteinte pour un éclairement 50 fois supérieur à celui qui engendre la saturation (mais on gagne en réduction du bruit engendré par le champ électrique entre grille et photodiode).

## Revendications

1. Procédé de commande d'un pixel d'un capteur d'image, dans lequel chaque pixel du capteur d'image comprend au moins une photodiode (PH) formée dans une couche active semiconductrice (12) par une région (14) dopée d'un premier type de conductivité recouverte par une région superficielle (16) du type opposé maintenue à un potentiel de référence nul, et une grille d'anti-éblouissement (G5) au-dessus de la couche active, adjacente d'un côté à la photodiode et d'un autre côté à un drain (22) d'évacuation de charges électriques connecté à un potentiel de référence, le capteur fonctionnant périodiquement avec à chaque période une durée d'intégration déterminée (Ti), **caractérisé en ce que** la grille d'anti-éblouissement est portée, pendant la plus grande partie de la durée d'intégration, à un potentiel de blocage créant dans la couche active sous la grille une barrière de potentiel d'une première hauteur, et, pendant une série d'impulsions brèves au cours de la durée d'intégration, à un potentiel d'anti-éblouissement positif (VR), créant sous la grille une barrière de potentiel d'une deuxième hauteur, plus faible que la première, cette dernière barrière de potentiel retenant les charges représentant l'éclairement dans la photodiode jusqu'à un seuil d'éblouissement.

2. Procédé selon la revendication 1, **caractérisé en ce que** le potentiel de blocage est égal au potentiel de référence nul.

3. Procédé selon l'une des revendications 1 et 2, **caractérisé en ce que** le potentiel de blocage est négatif par rapport au potentiel de référence nul.

4. Procédé selon l'une des revendications 1 à 3, **caractérisé en ce que** le potentiel d'anti-éblouissement est compris entre 0,5 et 0,9 volts.

5. Procédé selon l'une des revendications 1 à 4, **caractérisé en ce que** le rapport entre la durée d'intégration et la durée cumulée des impulsions est supérieur ou égal à 20.

6. Procédé selon l'une des revendications 1 à 5, **caractérisé en ce que** les impulsions sont périodiques et le rapport cyclique entre la période des impulsions et la durée des impulsions est supérieur ou égal à 20.

7. Procédé selon la revendication 6, **caractérisé en ce que** la période des impulsions est la période de lecture des lignes de pixels d'un capteur matriciel.

8. Capteur d'image comportant un réseau de pixels, chaque pixel comprenant au moins une photodiode (PH) constituée dans une couche active semiconductrice (12) par une région dopée (14) d'un premier type de conductivité recouverte par une région superficielle (16) du type opposé maintenue à un potentiel de référence nul, et au-dessus de la couche active une grille d'anti-éblouissement (G5) adjacente d'un côté à la photodiode et d'un autre côté à un drain (22) d'évacuation de charges électriques connecté à un potentiel de référence, le capteur étant configuré à fonctionner périodiquement avec à chaque période une durée d'intégration déterminée, le capteur étant **caractérisé en ce qu'**il comprend des moyens pour appliquer à la grille d'anti-éblouissement, pendant la plus grande partie de la durée d'intégration, un potentiel de blocage créant dans la couche active sous la grille une barrière de potentiel d'une première hauteur, et, pendant une série d'impulsions brèves au cours de la durée d'intégration, un potentiel d'anti-éblouissement (VR) créant sous la grille une barrière de potentiel d'une deuxième hauteur, plus faible que la première, cette dernière barrière de potentiel retenant les charges représentant l'éclairement dans la photodiode jusqu'à un seuil d'éblouissement.

9. Capteur d'image selon la revendication 8, **caractérisé en ce que** les moyens pour appliquer des impulsions sont aptes à produire des impulsions périodiques dont le rapport entre la période et la durée de l'impulsion est supérieur ou égal à 20.

## Patentansprüche

1. Verfahren zur Steuerung eines Pixels eines Bildsensors, wobei jedes Pixel des Bildsensors mindestens eine Photodiode (PH) umfasst, welche in einer aktiven Halbleiterschicht (12) durch einen Bereich (14) gebildet ist, welcher mit einer ersten Leitfähigkeitsart dotiert ist, bedeckt mit einem oberflächlichen Bereich (16) entgegengesetzter Art, welcher bei einem Referenzpotenzial von gleich null gehalten wird, und ein Blendschutzgitter (G5) oberhalb der aktiven Schicht, angrenzend einerseits an die Photodiode und andererseits an einen Drain (22) zur Ableitung elektrischer Lasten, welcher mit einem Referenzpotenzial verbunden ist, wobei der Sensor periodisch arbeitet, mit einer bestimmten Integrationsdauer (Ti) bei jeder Periode, **dadurch gekennzeichnet, dass** das Blendschutzgitter während des Großteils der Integrationsdauer auf ein Sperrpotenzial gebracht wird, welches in der aktiven Schicht unter dem Gitter eine Potenzialsperre einer ersten Höhe bildet, und während einer Reihe von kurzen Impulsen im Laufe der Integrationsdauer auf ein positives Blendschutzpotenzial (VR), welches unter dem Gitter eine Potenzialsperre einer zweiten Höhe bildet, welche geringer als die erste ist, wobei diese letztere Potenzialsperre die Ladungen zurückhält, welche die Beleuchtungsstärke in der Photodiode bis zu einer Blendschwelle darstellen.

2. Verfahren nach Anspruch 1, **dadurch gekennzeichnet, dass** das Sperrpotenzial gleich dem Referenzpotenzial gleich null ist.

3. Verfahren nach einem der Ansprüche 1 und 2, **dadurch gekennzeichnet, dass** das Sperrpotenzial gegenüber dem Referenzpotenzial gleich null negativ ist.

4. Verfahren nach einem der Ansprüche 1 bis 3, **dadurch gekennzeichnet, dass** das Blendschutzpotenzial zwischen 0,5 und 0,9 Volt liegt.

5. Verfahren nach einem der Ansprüche 1 bis 4, **dadurch gekennzeichnet, dass** das Verhältnis zwischen der Integrationsdauer und der kumulierten Dauer der Impulse größer als oder gleich 20 ist.

6. Verfahren nach einem der Ansprüche 1 bis 5, **dadurch gekennzeichnet, dass** die Impulse periodisch sind und das zyklische Verhältnis zwischen der Periode der Impulse und der Dauer der Impulse größer als oder gleich 20 ist.

7. Verfahren nach Anspruch 6, **dadurch gekennzeichnet, dass** die Periode der Impulse die Leseperiode der Pixelzeilen eines Matrixsensors ist.

8. Bildsensor der eine Pixelanordnung umfasst, wobei jedes Pixel mindestens eine Photodiode (PH) umfasst, welche in einer aktiven Halbleiterschicht (12) durch einen Bereich (14) gebildet ist, welcher mit einer ersten Leitfähigkeitsart dotiert ist, bedeckt mit einem oberflächlichen Bereich (16) entgegengesetzter Art, welcher bei einem Referenzpotenzial von null gehalten wird, und ein Blendschutzgitter (G5) oberhalb der aktiven Schicht, angrenzend einerseits an die Photodiode und andererseits an einen Drain (22) zur Ableitung elektrischer Lasten, welche mit einem Referenzpotenzial verbunden ist, wobei der Sensor **dadurch gekennzeichnet ist, dass** er periodisch arbeitet, mit einer bestimmten Integrationsdauer bei jeder Periode, wobei der Sensor **dadurch gekennzeichnet ist, dass** er Mittel zum Anlegen eines Sperrpotenzials an das Blendschutzgitter über den Großteil der Integrationsdauer umfasst, welches in der aktiven Schicht unter dem Gitter eine Potenzialsperre einer ersten Höhe bildet, und, während einer Reihe von kurzen Impulsen im Laufe der Integrationsdauer, eines Blendschutzpotenzials (VR), welches unter dem Gitter eine Potenzialsperre einer zweiten Höhe bildet, welche geringer als die erste ist, wobei diese letztere Potenzialsperre die Ladungen zurückhält, welche die Beleuchtungsstärke in der Photodiode bis zu einer Blendschwelle darstellen.

9. Bildsensor nach Anspruch 8, **dadurch gekennzeichnet, dass** die Mittel zum Anlegen von Impulsen in der Lage sind, periodische Impulse zu erzeugen, deren Verhältnis zwischen der Periode und der Impulsdauer größer als oder gleich 20 ist.

## Claims

1. A method for controlling a pixel of an image sensor, wherein each pixel of the image sensor comprises at least one photodiode (PH) formed in a semiconductor active layer (12) by a doped region (14) of a first type of conductivity covered by a superficial region (16) of the opposite type maintained at a nil reference potential, and an anti-blooming gate (G5) above the active layer, adjacent on one side to the photodiode and on another side to a drain (22) for evacuating electric charges, connected to a reference potential, the sensor operating periodically with at each period a determined duration of integration (Ti), **characterized in that** the anti-blooming gate is set, during most of the duration of integration, to a blocking potential creating in the active layer beneath the gate a potential barrier of a first height, and, during a series of brief pulses over the duration of integration, to a positive anti-blooming potential (VR) creating beneath the gate a potential barrier of a second height, lower than the first, this latter potential barrier retaining the charges representing the lighting in the photodiode up to a blooming threshold.

2. The method as claimed in claim 1, **characterized in that** the blocking potential is equal to the nil reference potential.

3. The method as claimed in one of claims 1 and 2, **characterized in that** the blocking potential is negative with respect to the nil reference potential.

4. The method as claimed in one of claims 1 to 3, **characterized in that** the anti-blooming potential lies between 0.5 and 0.9 volts.

5. The method as claimed in one of claims 1 to 4, **characterized in that** the ratio of the duration of integration to the cumulative duration of the pulses is greater than or equal to 20.

6. The method as claimed in one of claims 1 to 5, **characterized in that** the pulses are periodic and the duty ratio of the period of the pulses to the duration of the pulses is greater than or equal to 20.

7. The method as claimed in claim 6, **characterized in that** the period of the pulses is the read-out period of the rows of pixels of a matrix sensor.

8. An image sensor including an array of pixels, each pixel comprising at least one photodiode (PH) constituted in a semiconductor active layer (12) by a doped region (14) of a first type of conductivity covered by a superficial region (16) of the opposite type maintained at a nil reference potential, and above the active layer an anti-blooming gate (G5) adjacent on one side to the photodiode and on another side to a drain (22) for evacuating electric charges, connected to a reference potential, the sensor being configured to operate periodically with in each period a determined duration of integration, the sensor being **characterized in that** it comprises means for applying to the anti-blooming gate, during most of the duration of integration, a blocking potential creating in the active layer beneath the gate a potential barrier of a first height, and, during a series of brief pulses over the duration of integration, an anti-blooming potential (VR) creating beneath the gate a potential barrier of a second height, lower than the first, this latter potential barrier retaining the charges representing the lighting in the photodiode up to a blooming threshold.

9. The image sensor as claimed in claim 8, **characterized in that** the means for applying pulses are able to produce periodic pulses in which the ratio of the period to the duration of the pulse is greater than or equal to 20.
